# EUROPEAN PATENT APPLICATION

(11) **EP 2 200 414 A2**
(43) Date of publication of application: **23.06.2010**
(21) Application number: 09252601.1
(22) Date of filing: 11.11.2009
(51) Int. Cl.: H05K 3/46

(54) **Integrated circuit package**

(30) Priority: 03.12.2008 GB 0822089
(71) Applicant: Thales Holdings UK Plc, Addlestone, Surrey KT15 2NX (GB)
(72) Inventor: Loiselet, Emmanuel, Crawley, Surrey RH10 2RL (GB)
(74) Representative: Maury, Richard Philip

(57) **Abstract**

An integrated circuit package comprising at least two printed circuit boards each comprising a substrate coated with metallic layers on both sides and having plated through-holes for electrical and thermal connection to the metallic layers, at least two of the printed circuit boards being diffusion-bonded at an interface between their respective metallic layers, the bonded metallic layers forming an hermetic seal between the opposed external surfaces of the integrated circuit package.

## Description

This invention relates to an integrated circuit package comprising plural printed circuit boards, and to a method of making such a package. It is particularly, although not exclusively, concerned with hermetically-sealed packages for high power amplifiers.

Heat dissipation from printed circuit boards poses a serious problem particularly in the case of high power amplifiers: integrated circuit chips for such amplifiers can for example generate in excess of 3W each, and for some applications such as antenna arrays with several thousand chips the power consumption can be 30 kW or more, Part of the problem lies in the high level of spatial integration using multiple layers of PCBs, since it becomes difficult to arrange for a short path length between the heat generators and the heat sinks. Excessive temperatures can permanently damage the integrated circuits.

The use of a ball grid array, BGA, facilitates assembly of a sealed integrated circuit chip, for example, onto a printed circuit, and can allow for replacement of such a chip using soldering/desoldering techniques. Thermal dissipation from such a chip is conventionally done through a set of the balls of the BGA, using thermally conductive via holes, also known as vias or through-holes, through the underlying printed circuit board, through to a heat sink which may be a heat sink or a metallic girder and may have a fluid cooling system running through it. However, such arrangements often have an unsatisfactory rate of thermal transfer.

Packages of printed circuit boards, with plated through-holes providing electrical interconnection between metallic printed circuits on the surfaces of the boards, are known for example from US2004/0060173A.

A requirement for hermetically-sealed integrated circuit packages with good thermal management for high power amplifiers, such as in active array antennas for radars, has not been met satisfactorily. Accordingly, the purpose of the present invention is to overcome the limitations of previous integrated circuit arrangements, to satisfy this requirement.

Accordingly, the present invention provides an integrated circuit package comprising at least two printed circuit boards each comprising a substrate coated with metallic layers on both sides and having plated through-holes for electrical and thermal connection to the metallic layers, at least two of the printed circuit boards being diffusion-bonded at an interface between their respective metallic layers, the bonded metallic layers forming an hermetic seal between the opposed external surfaces of the integrated circuit package.

The invention also provides a method of making such an integrated circuit package, comprising diffusion-bonding opposed surfaces of at least two of the printed circuit boards at the said interface.

In order that the invention may be better understood, a preferred embodiment will now be described, by way of example only, with reference to the accompanying drawings, in which:
Figure 1 (prior art) is a cross-section through part of an assembly of a multi-layer printed circuit board (PCB) over a heat sink layer, with a sealed integrated circuit box connected through a ball grid array (BGA);
Figure 2 is a partially broken away view of an hermetically-sealed box including an hermetically-sealed integrated package embodying the invention;
Figure 3 illustrates three stages of a process embodying the present invention of manufacturing an integrated circuit package; and
Figure 4 is a graph showing the time variation of temperature and pressure for diffusion bonding in a method embodying the present invention.

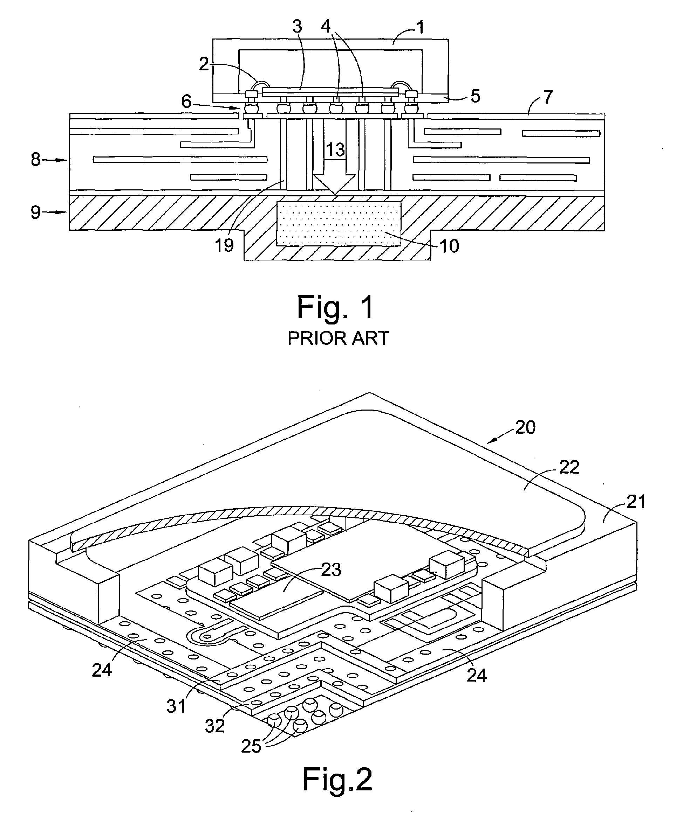

Corresponding components in the different drawings are given the same reference numerals. As shown in Figure 1, an hermetically sealed integrated circuit box 1 has for its base a PCB 5 with an array of through-holes 4 to a BGA 6 comprising solder balls, as is well known. A high power integrated circuit, such as a power amplifier 3, is mounted on the PCB 5 and external leads connect it to peripheral interconnection pads on the PCB 5. The BGA 6 is bonded with good electrical and thermal contact to a printed circuit 7 on a PCB 8 which itself is bonded to the upper surface of a metallic girder 9 which acts as a heat sink and conveys heat away from the box 1, through the BGA, to further heat sinks such as exposed fins (not shown). The heat sink 9 has an enclosed channel 10 for a fluid cooling system. Thermal transfer shown by the arrow 13 through the PCB 8 is achieved with the use of narrow vertical channels 19.

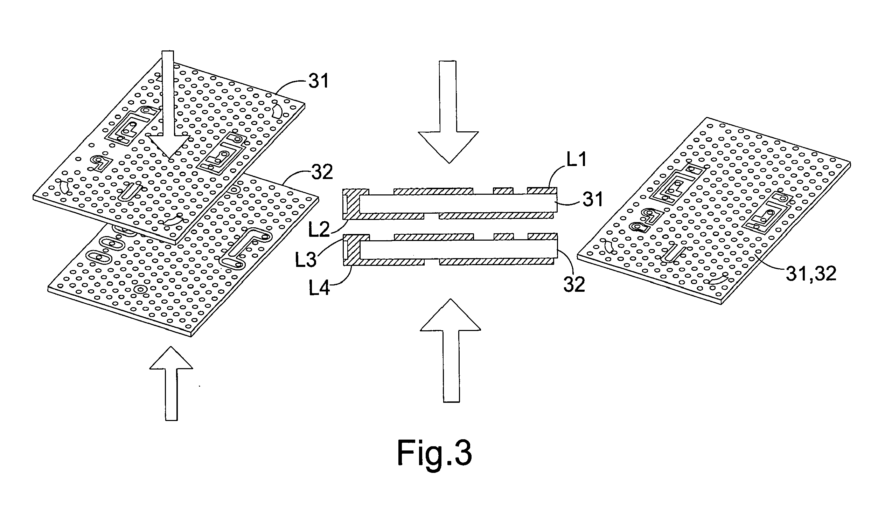

As shown in Figure 2, an hermetically-sealed box 20 comprising a high power amplifier has on its lower external surface a BGA comprising solder balls 25 for thermal and electrical connection to an external circuit board, for example adjacent a radar antenna. The box comprises a cover 22 and four walls 21 made of copper-beryllium, the under surfaces of the walls being bonded by brazing to an integrated circuit package 31, 32 by a tin-lead-copper solder layer 24. The integrated circuit package, which embodies the present invention, comprises, in this example, two PCB 31, 32 each of which has a copper coating on both sides, as shown more clearly in Figure 3. Each PCB has a substrate formed of glass-reinforced hydrocarbon ceramic substrate, K-HC. The BGA 25 is formed on the under surface of the integrated circuit package. The high power amplifier circuit 23, which comprises Ga-As chips set on a heat spreader which can be a Molybdenum tab, is bonded electrically and thermally to the external upper surface of the upper PCB 31.

As shown in Figure 3, the PCB 31 and 32 are diffusion-bonded together at an interface between their metallic coating layers L2 and L3. The upper PCB 31 has upper and lower printed circuit layers, L1 and L2, whilst the lower PCB 32 has corresponding layers, L3 and L4.

Each PCB is formed with an array of through-holes which are copper-plated over their cylindrical walls, the platings being joined to portions of the metallic layers L1 to L4. In this example, an RF signal path extends through two aligned through-holes. Other electrical paths are formed through offset through-holes, from a portion of printed circuit L1, through a through-hole in PCB 31 to a portion of the interfacing printed circuits L2 and L3, then laterally through this interface to an offset through-hole in the PCB 32, and then to the printed circuit L4 for connection to a solder ball of the BGA 25.

The diffusion bonding at the interface L2, L3 of the PCB 31, 32 provides an hermetical seal across the package, except only for the RF signal path through the aligned through-holes (not shown on fig 3), which is independently hermetically sealed.

Whilst in this example there are just two PCB there may be three or more PCB in a multi-layer structure. Also, whilst in this example there are several offset through-holes with electrical paths, it is not essential for such through-holes to be offset; however, offsetting improves the level of hermeticity of the package.

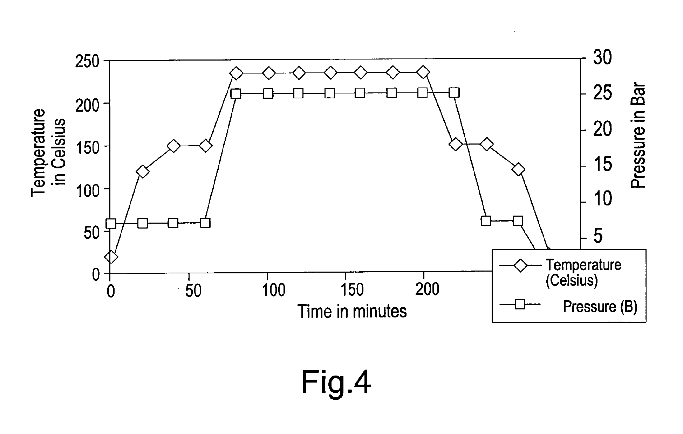

In this example, the printed circuits L2 to L4 are primarily of copper which is bonded to the substrate. At the interface between layers L2 and L3, a diffusion bond is formed between a gold or nickel-gold coating on one of the layers and a tin or nickel-tin coating on another of the layers. Under appropriate conditions of pressure and temperature as described below with reference to Figure 4, the gold and tin diffuse to formed a eutectic crystal layer. Alternative materials to the tin and gold are feasible, such as gold and gold, tin and tin, or alternative metals or alloys.

The diffusion bonding process will now be described with reference to Figure 4, which shows the variation over time of the temperature of the PCB and the pressure at the interface between them. As can be seen from Figure 4, the temperature is progressively increased from room temperature to 150C over a period of about one hour, during which the pressure is maintained at a little over 5 Bar or 5x10⁵ Pa. During the next phase which lasts over an hour and preferably about three hours, the temperature is held constant at about 240C, and the pressure is held constant at about 25 Bar or 2.5x10⁶ Pa. After this, the temperature and pressure are allowed to decrease back to normal ambient conditions, over a period of over an hour. The maximum temperature is preferably over 200C. The maximum pressure is preferably over 20 Bar or 2x10⁶ Pa. However, variations in these ranges of pressure and temperature will of course be feasible depending upon the materials involved and the level of hermeticity required.

A preferred process for producing each PCB will now be described.

First, a double-sided substrate is drilled with through-holes. A thin layer of copper, preferably one to three microns thick, is chemically deposited inside the through-holes and all over the substrate. A plating resist layer is then applied to both surfaces of the coated substrate, using a photo-imaging process, as is well known in the art. Using this resist layer, a thick copper layer is then deposited by electro plating inside the through-holes and over the surfaces of the substrate, except for those portions defined by the resist layer. This electroplated copper layer is preferably 10 to 20 microns thick. Using the resist layer again, a nickel-gold layer is electroplated over the copper layer, inside the through-holes and over both surfaces of the substrate. The nickel-gold plating comprises a nickel layer 5 microns thick and a gold layer 3 microns thick. The resist layer is then removed by etching. The etching is then continued to remove the underlying copper layer, leaving the copper and gold coatings within the through-holes and on both surfaces of the PCB. Another PCB is prepared in a similar fashion, and then the two PCB are bonded together, with their through-holes usually offset, but such that the interfacing gold-copper coatings, or gold-copper and tin-copper coatings, bond together.

## Claims

1. An integrated circuit package comprising at least two printed circuit boards each comprising a substrate coated with metallic layers on both sides and having plated through-holes for electrical and thermal connection to the metallic layers, at least two of the printed circuit boards being diffusion-bonded at an interface between their respective metallic layers, the bonded metallic layers forming an hermetic seal between the opposed external surfaces of the integrated circuit package.

2. A package according to Claim 1, in which at least one of the diffusion-bonded metallic layers comprises copper coated with gold or nickel-gold.

3. A package according to Claim 1 or Claim 2, in which at least one of the diffusion-bonded metallic layers comprises copper coated with tin or nickel-tin.

4. A package according to Claim 1, in which the interface is between a tin on copper metallic layer and a gold on copper metallic layer.

5. A package according to any preceding claim, in which at least one of the through-holes in a first one of the printed circuit boards is offset from the through-holes in an adjacent, second one of the printed circuit boards with which it interfaces, such that the through-hole of the first printed circuit board is in electrical and thermal contact with at least one through-hole of the second printed circuit board through portions of the interfacing metallic layers.

6. A package according to any preceding claim, in which each substrate is of glass-reinforced hydrocarbon ceramic, GHC, material.

7. A method of making an integrated circuit package according to any preceding claim, comprising diffusion-bonding opposed surfaces of at least two of the printed circuit boards at the said interface.

8. A method according to Claim 7, comprising diffusion bonding at a pressure of over 2x10⁶ Pa (20 Bar).

9. A method according to Claim 7 or Claim 8, comprising diffusion bonding at a temperature of over 200C.

10. A method according to any of Claims 7, 8, and 9, comprising diffusion bonding for a duration of at least one hour.

11. A method according to any of Claims 7, 8 and 9, comprising diffusion bonding for a period of at least one hour at a temperature of between 50C and 100C and at a pressure of between 2x10⁵ and 1x10⁶ Pa (2 to 10 Bar), followed by a period of between one and two hours at a temperature of between 200C and 300C and at a pressure of between 2x10⁶ and 3x10⁶ Pa (20 to 30 Bar), followed by a period of between one and two hours at decreased pressures and temperatures.
